# EUROPEAN PATENT APPLICATION

(11) **EP 4 844 485 A1**
(43) Date of publication of application: **25.11.2026**
(21) Application number: 25177603.5
(22) Date of filing: 20.05.2025
(51) Int. Cl.: G03F 7/00

(54) **HIGH-SPEED NOZZLE SWITCHING**

(71) Applicant: ASML Netherlands B.V., 5500 AH Veldhoven (NL)
(72) Inventor: VAN DEN AKKER, Emericus, Antoon, Theodorus, 5500 AH Veldhoven (NL); BHARDWAJ, Shikhar, 5500 AH Veldhoven (NL); HUANG, Zhuangxiong, 5500 AH Veldhoven (NL); DEMIRKESEN, Cem, 5500 AH Veldhoven (NL)
(74) Representative: ASML Netherlands B.V.

(57) **Abstract**

A gas supply apparatus for a lithographic apparatus. The gas supply apparatus comprises a nozzle configured to provide a flow of protective gas from a gas source to protect a patterning device of the lithographic apparatus. The gas supply apparatus comprises a valve configured to control a flow rate of the flow of protective gas provided by the nozzle. The gas supply apparatus is configured to provide the flow of protective gas at a flow rate dependent on a spacing between a plurality of masking blades of the lithographic apparatus.

## Description

### FIELD

The present invention relates to a gas supply apparatus for a lithographic apparatus, and a method of of providing a flow of protective gas to protect a patterning device of a lithographic apparatus using a gas supply apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Contaminants present on the patterning device may absorb and/or scatter the electromagnetic radiation, altering the pattern projected onto the substrate and thereby degrading the performance of the lithographic apparatus. To reduce the risk of contaminants contacting the patterning device, a nozzle may direct a purging gas towards the patterning device, to establish a gas flow forcing contaminants away from the patterning device. To further reduce the risk of contamination, the patterning device may comprise a protective membrane (e.g., a pellicle) which at least partially covers the patterning device. However, the combination of providing purging gas and performing scanning operations of the lithographic apparatus may result pressure variations in proximity to the patterning device which may also degrade the performance of the lithographic apparatus. Increases in purging gas pressure in proximity to the patterning device may deform the protective membrane, resulting in a reduction in overlay performance and/or rupturing the pellicle. Variations in the purging gas pressure may also inhibit the optimal performance of optical sensors in the region of the patterning device, reducing measurement accuracy. Further, variations in the purging gas pressure may result in a greater perturbation in the flow pattern local to the patterning device, increasing the risk of contamination of the patterning device.

### SUMMARY

According to a first aspect of the invention, there is provided a gas supply apparatus for a lithographic apparatus. The gas supply apparatus comprises a nozzle configured to provide a flow of protective gas from a gas source to protect a patterning device of the lithographic apparatus. The gas supply apparatus comprises a valve configured to control a flow rate of the flow of protective gas provided by the nozzle. The gas supply apparatus is configured to provide the flow of protective gas at a flow rate dependent on a spacing between a plurality of masking blades of the lithographic apparatus.

Providing the flow of protective gas at a flow rate dependent on the spacing between the masking blades has the technical effect of reducing pressure variations in the mini-environment around the patterning device. This technical effect has the advantage of reducing scale of deformation of the protective membrane, reducing the risk of damage to the protective membrane and/or improving overlay accuracy. This technical effect also has the advantage of the improving the performance of optical sensors (e.g., metrology sensors) in proximity to the patterning device, by reducing the pressure fluctuations which degrade measurement accuracy. This technical effect also results in a more stable local flow pattern in proximity to the patterning device, reducing gas flow perturbations and the associated risk that contaminants come into contact with the patterning device.

The gas supply apparatus may be configured to provide the flow of protective gas from the nozzle at a first flow rate when the plurality of making blades are in a closed configuration. The gas supply apparatus may be configured to provide the flow of protective gas from the nozzle at a second flow rate when the plurality of masking blades are in an open configuration. The first flow rate is less than the second flow rate.

By providing the flow of protective gas at a lower and/or low flow rate, the formation of a high-pressure region between the patterning device and the masking blades can be avoided. Avoiding the formation of a high-pressure region between the patterning device and the masking blades may advantageously reduce deformation of the protective membrane, improving the accuracy of the projection at the substrate level, and/or reducing the risk of rupturing the protective membrane. Further, using a lower flow rate does not significantly increase the risk that the patterning device will become contaminated because in the closed configuration the masking blades inhibit the transmission of contaminants into the mini-environment around the patterning device.

The valve may have a switching time of less than or equal to 10 ms.

Using a faster valve switching time enables the gas supply apparatus to respond more quickly to the change in spacing between the masking blades, allowing for more precise control/dependency of the gas flow rate on the masking blade spacing.

The valve may be positioned in proximity to a gas supply inlet of the nozzle.

Placing the valve in proximity to the nozzle improves the speed at which the gas supply apparatus can vary the flow rate of the flow of protective gas because a smaller combined volume of nozzle and conduit downstream of the valve is filled or emptied when the valve is switched.

The valve may be a piezoelectric valve.

The valve may be configured to control the flow rate in response to receiving an input from a controller.

According to a second aspect of the invention, there is provided a method of providing a flow of protective gas to protect a patterning device of a lithographic apparatus using a gas supply apparatus. The method comprises determining a spacing between a plurality of masking blades of the lithographic apparatus. The method comprises adjusting, dependent on the spacing between the plurality of masking blades, the flow rate of the flow of protective gas from a nozzle of the gas supply apparatus. The flow rate of the flow of protective gas is adjusted using a valve of the gas supply apparatus

Adjusting the flow rate of the flow of protective gas may comprise providing the flow of protective gas from the nozzle at a first flow rate when the plurality of making blades are in a closed configuration. Adjusting the flow rate of the flow of protective gas may comprise providing the flow of protective gas from the nozzle at a second flow rate when the plurality of masking blades are in an open configuration. The first flow rate may be less than the second flow rate.

According to a third aspect of the invention, there is provided a gas supply apparatus for a lithographic apparatus. The gas supply apparatus comprises a nozzle configured to provide a flow of protective gas from a gas source to protect a lens top element of the lithographic apparatus. The gas supply apparatus comprises a valve configured to control a flow rate of the flow of protective gas provided by the nozzle. The gas supply apparatus is configured to provide the flow of protective gas at a flow rate dependent on a scan motion of a patterning device relative to the nozzle.

Providing the flow of protective gas at a flow rate dependent on the scan motion of the patterning device has the technical effect of reducing pressure variations in the mini-environment around the patterning device. This technical effect has the advantage of reducing scale of deformation of the protective membrane, reducing the risk of damage to the protective membrane and/or improving overlay accuracy.

The gas supply apparatus may be configured to provide the flow of protective gas from the nozzle at a first flow rate when the scan motion of the patterning device is directed away from the nozzle. The gas supply apparatus may be configured to provide the flow of protective gas from the nozzle at a second flow rate when the scan motion of the patterning device is directed towards the nozzle. The first flow rate is greater than the second flow rate.

By reducing the flow rate of the flow of protective gas when the scan motion of the patterning device is directed towards the nozzle, the gas flow from the nozzle exerts a smaller force on the protective membrane, reducing deformation of the protective membrane. Reduced deformation of the protective membrane reduces undesirable refraction of the patterned radiation beam , improving projection/overlay accuracy at the substrate. Further, reducing deformation of the protective membrane, particularly when the scan motion of the patterning device is directed towards the nozzle, improves the consistency of the projection across the scanning operation in which the patterning device moves towards and away from the nozzle in the scanning axis.

The gas supply apparatus may be configured to provide the flow of protective gas from the nozzle at the first flow rate by widening the valve. The gas supply apparatus may be configured to provide the flow of protective gas from the nozzle at the second flow rate by narrowing the valve.

The valve may have a switching time of less than or equal to 10 ms.

Using a faster valve switching time enables the gas supply apparatus to respond more quickly to the change in direction of the patterning device MA, allowing for more precise dependency of the gas flow rate on the scan motion of a patterning device relative to the nozzle.

The valve may be positioned in proximity to a gas supply inlet of the nozzle.

Placing the valve in proximity to the gas supply inlet of the nozzle improves the speed at which the gas supply apparatus can vary the flow rate of the flow of protective gas because a smaller combined volume of nozzle and conduit downstream of the valve is filled or emptied when the valve is switched.

The valve may be a piezoelectric valve.

The valve may be configured to control the flow rate in response to receiving an input from a controller.

The gas supply apparatus may comprise an auxiliary nozzle configured to provide an auxiliary flow of protective gas from an auxiliary gas source to the patterning device of the lithographic apparatus. The gas supply apparatus may comprise an auxiliary valve configured to control the flow rate of the auxiliary flow of protective gas from the auxiliary nozzle.

The use of an auxiliary nozzle ensures that the flow of protective gas is can be provided in the scan direction of the patterning device across the whole of a scanning operation, enabling the lithographic apparatus to maintain the same protective gas flow condition with respect to the frame of reference of the patterning device. Maintaining the same protective gas flow condition further reduces variations in deformation of the protective membrane during scan operations compared to the single nozzle example, resulting in further improvements to the projection accuracy at the substrate level. Additionally, the use of the auxiliary nozzle ensures a constant flow of refreshment protective gas is provided, diluting the concentration of contaminants in the lens top mini environment. As previously discussed, contaminants may interfere with the patterned radiation beam reducing overlay performance and damage the optical surfaces comprising the lens top element. Diluting the concentration of contaminants in the lens top mini-environment, therefore improves the overlay performance of the lithographic apparatus and improves the optics lifetime. The auxiliary nozzle may be positioned such that the auxiliary flow of protective gas provided by the auxiliary nozzle flows in a different direction to the flow of protective gas provided by the nozzle. The auxiliary nozzle may be positioned such that the auxiliary flow of protective gas provided by the auxiliary nozzle flows in an opposite direction to the flow of protective gas provided by the nozzle.

The gas supply apparatus may be configured to provide the auxiliary flow of protective gas from the auxiliary nozzle at a third flow rate when the motion of the patterning device is directed away from the auxiliary nozzle. The gas supply apparatus may be configured to provide the auxiliary flow of protective gas from the auxiliary nozzle at a fourth flow rate when the motion of the patterning device is directed towards the auxiliary nozzle. The third flow rate is greater than the fourth flow rate.

According to a fourth aspect of the invention, there is provided a method of providing a flow of protective gas to protect a patterning device of a lithographic apparatus using a gas supply apparatus. The method comprises determining a scan motion of the patterning device relative to a nozzle of the gas supply apparatus. The method comprises adjusting, dependent on the scan motion of the patterning device relative to the nozzle, the flow rate of the flow of protective gas. The flow rate of the flow of protective gas is adjusted using a valve of the gas supply apparatus.

Adjusting the flow rate of the flow of protective gas may comprise providing the flow of protective gas from the nozzle at a first flow rate when the scan motion of the patterning device is directed away from the nozzle. Adjusting the flow rate of the flow of protective gas may comprise providing the flow of protective gas from the nozzle at a second flow rate when the scan motion of the patterning device is directed towards the nozzle. The first flow rate may be greater than the second flow rate.

According to a fifth aspect of the invention, there is provided a lithographic apparatus. The lithographic apparatus comprising an illumination system configured to condition a radiation beam. The lithographic apparatus comprising a support structure constructed to support a patterning device, the patterning device being capable of imparting the radiation beam with a pattern in its cross-section to form a patterned radiation beam. The lithographic apparatus comprising a gas source. The lithographic apparatus comprising a gas supply apparatus, of the first aspect or the third aspect, in fluid communication with the gas source

### BRIEF DESCRIPTION OF THE DRAWINGS

Embodiments of the invention will now be described, by way of example only, with reference to the accompanying schematic drawings, in which:
- Figure 1 depicts a first lithographic system comprising a lithographic apparatus and a radiation source;
- Figure 2a depicts a gas supply apparatus for a lithographic apparatus in which a plurality of masking blades are in a closed configuration;
- Figure 2b depicts a gas supply apparatus for a lithographic apparatus in which a plurality of masking blades are in an open configuration;
- Figure 3a depicts the position of the patterning device over time;
- Figure 3b depicts the position of a plurality of masking blades over time;
- Figure 3c depicts the pressure difference over a patterning device in a lithographic apparatus in which the flow rate at which a protective gas is provided is not dependent upon a spacing between a plurality of masking blades;
- Figure 4a depicts a gas supply apparatus for a lithographic apparatus, according to an example of the invention, in which a plurality of masking blades are in a closed configuration;
- Figure 4b depicts a gas supply apparatus for a lithographic apparatus, according to an example of the invention, in which a plurality of masking blades are in an open configuration;
- Figure 5a depicts the operation of a gas supply apparatus, according to an example of the invention, in which the flow rate at which a protective gas is provided is dependent upon a spacing between a plurality of masking blades;
- Figure 5b depicts the pressure difference over a patterning device in a lithographic apparatus in which the flow rate at which a protective gas is provided is dependent upon a spacing between a plurality of masking blades, according to an example of the invention;
- Figure 6 depicts a second lithographic system comprising a lithographic apparatus and a radiation source;
- Figure 7 depicts a gas supply apparatus for a lithographic apparatus in which the scan motion of the patterning device is directed away from the nozzle;
- Figure 8a depicts a gas supply apparatus for a lithographic apparatus, according to an example of the invention, in which the scan motion of the patterning device is directed away from the nozzle;
- Figure 8b depicts a gas supply apparatus for a lithographic apparatus, according to an example of the invention, in which the scan motion of the patterning device is directed towards the nozzle;
- Figure 9 depicts a gas supply apparatus for a lithographic apparatus, comprising an auxiliary nozzle, in which the scan motion of the patterning device is directed towards the nozzle and away from the nozzle;
- Figures 10a and 10b depict a valve configured to control a flow rate of protective gas provided by a nozzle;
- Figures 11a and 11b depict a valve configured to control a flow rate of protective gas provided by a nozzle
- Figure 12 depicts a method of providing a flow of protective gas to protect a patterning device of a lithographic apparatus using a gas supply apparatus; and
- Figure 13 depicts a method of providing a flow of protective gas to protect a patterning device of a lithographic apparatus using a gas supply apparatus.

### DETAILED DESCRIPTION

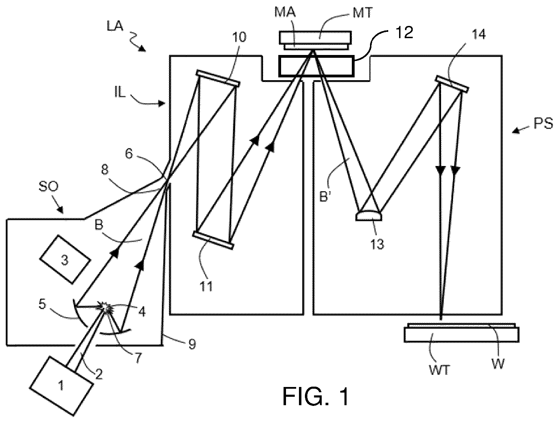

Figure 1 shows a first lithographic system comprising a radiation source SO and a lithographic apparatus LA (e.g., an EUV lithographic apparatus). The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The region of the patterning device MA illuminated by the EUV radiation beam B as partially or wholly defined by the masking module 12 may be referred to as the illumination region. The illumination region may be smaller than the patterning device MA in one or more directions.

In some examples the patterning device MA may comprise a reticle and/or any other suitable patterning device. The patterning device MA may further comprise a protective membrane. The protective membrane may be configured to inhibit contamination of the patterning device MA. The protective membrane may be a pellicle and/or any other suitable protective membrane.

In an example lithographic apparatus LA, the lithographic apparatus LA may be a scanning lithographic apparatus LA. In a scanning lithographic apparatus LA the patterning device support structure MT may be movable in a scanning direction Y so as to expose a greater region of the patterning device MA in a single dynamic scanning exposure. The patterning device support structure MT is movably mounted. The lithographic apparatus LA may be considered to comprise a scanning module operable to move the patterning device support structure MT relative to a support frame. The EUV radiation beam B may have an extent which can only illuminate a portion of the patterning device MA in the scanning direction Y at any one time. The movement of the patterning device support structure MT allows a greater area of the patterning device MA to move through the path of the EUV radiation beam B, cumulatively exposing a greater region of the patterning device MA to electromagnetic radiation B in a single dynamic scanning exposure.

The lithographic apparatus LA also comprises one or more protective gas sources, and one or more protective gas supply apparatus in fluid communication with the one or more protective gas sources. The protective gas supply apparatus may be configured to provide a flow of protective gas to various elements of the lithographic apparatus LA (e.g., the patterning device MA), to inhibit the passage of contaminants to the patterning device MA. The protective gas may be hydrogen, or any other suitable gas and/or fluid for this purpose.

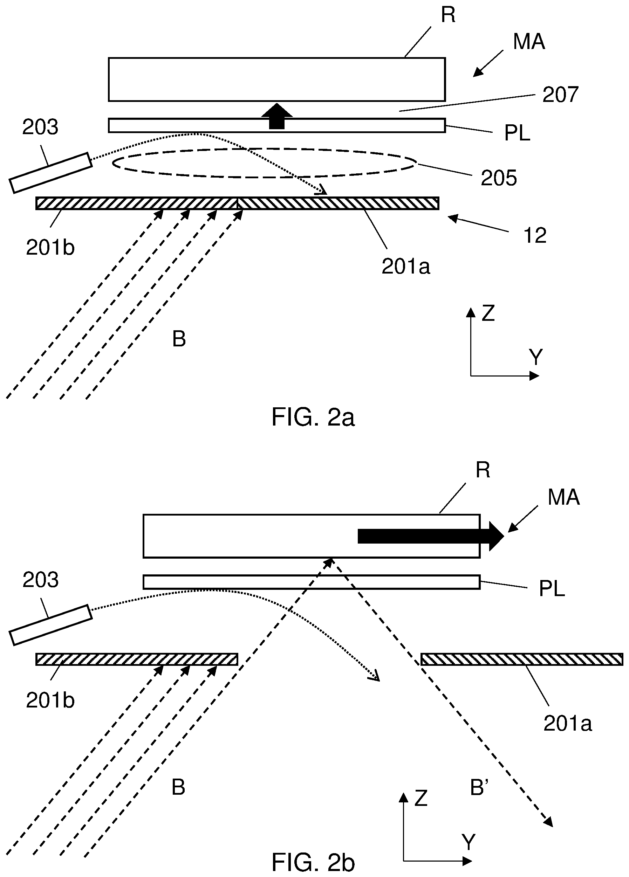

In the example of Figure 2a, the masking module 12 comprises a plurality of masking blades 201. In this example the masking module 12 comprises two masking blades 201, a first masking blade 201a and a second masking blade 201b. The skilled person would appreciate that any suitable number of masking blades could be used. In the examples of Figure 2a (and Figure 2b), the length of the masking blades 201 is aligned perpendicular to the scanning direction Y (parallel to the non-scanning direction X) of the patterning device MA, and so the masking blades are Y masking blades (e.g., REMA Y-blades).

In the example of Figure 2a, both the first masking blade 201a and the second masking blade 201b inhibit the transmission of the electromagnetic radiation B to the patterning device MA. This is depicted in Figure 2a by the dashed arrows terminating at the masking blades 201. The masking blades 201 depicted in Figure 2a are in a closed configuration. In the example of Figure 2a, the internal edges of the masking blades 201 abut one another. In some examples, in the closed configuration, the internal edges of the masking blades 201 may be in close proximity to one another. In some examples, in the closed configuration, the area of the spacing between the internal edges of the masking blades 201 may be less than or equal to 0.005 m². The electromagnetic radiation B is inhibited from transmitting through the masking module 12 to the patterning device MA because the spacing between the masking blades 201 is too small to permit the transmission of electromagnetic radiation B to the patterning device MA.

In the example of Figure 2a (and Figure 2b), the patterning device MA comprises a mask and/or reticle R and a protective membrane PL. In some examples (not shown), the patterning device MA comprises a mask and/or reticle R, but does not comprise a protective membrane PL.

In the example of Figure 2a, the lithographic apparatus LA comprises a gas supply apparatus. The gas supply apparatus comprises a nozzle 203 configured to provide a flow of protective gas (dotted arrow) from a gas source (not shown) to protect a patterning device MA of the lithographic apparatus LA. In the example of Figure 2a, the nozzle 203 is positioned between the masking blades 201 and the patterning device MA with respect to the Z direction. In some examples the nozzle 203 may be configured to be positioned such that a component of the protective gas flow is directed parallel to the scanning axis Y of the patterning device MA. In the example of Figure 2a the flow of protective gas is directed towards the protective membrane PL of the patterning device MA. In examples where the patterning device MA does not comprise a protective membrane PL, the flow of protective gas would be directed towards a mask and/or reticle of the patterning device MA. As illustrated in Figure 2a, the flow of protective gas deflects from the patterning device MA. However, in Figure 2a the masking blades 201 are in a closed configuration, inhibiting the egress of the flow of protective gas from mini-environment around the patterning device MA, thereby creating a high-pressure region 205 between the masking blades 201 and the patterning device MA.

The creation of a high-pressure region 205 between the masking blades 201 and the patterning device MA is deleterious to the performance of the lithographic apparatus. In embodiments in in which the patterning device MA comprises a protective membrane PL (as in Figure 2a), the difference in pressure between the bottom of the protective membrane PL facing the high-pressure region 205 and the top of the protective membrane PL facing a lower-pressure region 207 may exert a non-zero net force on the protective membrane (as illustrated by the arrow in Figure 2a), deforming the protective membrane PL into the lower-pressure region 207. Deformation of the protective membrane PL in this manner may result in a reduction in the accuracy of the projection at the substrate W level (i.e., overlay accuracy) and/or may rupture of the protective membrane PL increasing the risk of contaminants contacting the mask and/or reticle R.

In the example of Figure 2b, the patterning device MA and first masking blade 201a have moved in the scanning direction Y, relative to their positions in Figure 2a. Whilst the second masking 201b blade inhibits the transmission of a first portion of the electromagnetic radiation B, a second portion of the electromagnetic radiation B may transmit to the patterning device MA through the opening between the masking blades 201. The second portion of the electromagnetic radiation B may then interact with the patterning device MA, forming a patterned radiation beam B' which may be projected onto the substrate W.

The masking blades 201 depicted in Figure 2b are in an open configuration. In the example of Figure 2b, the internal edges of the masking blades 201 do not abut one another. In some embodiments, in the open configuration, the area of the spacing between the internal edges of the masking blades 201 may be greater than 0.005 m².

As for Figure 2a, in Figure 2b the flow of protective gas (dotted line) from the nozzle 203 of the gas supply apparatus deflects from the patterning device MA. In contrast to Figure 2b, the masking blades 201 are in an open configuration, and so egress of the flow of the protective gas from mini-environment around the patterning device MA is not inhibited. As such, the formation of a high-pressure region 205 (as in FIG. 2a) between the masking blades 201 and the patterning device MA is avoided.

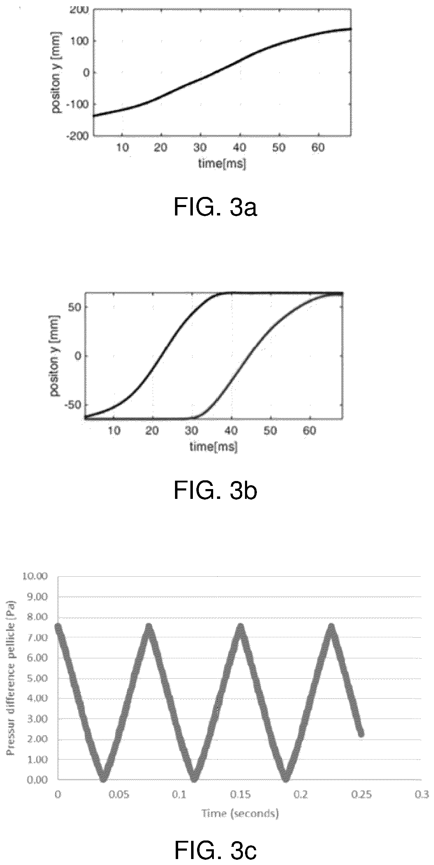

As depicted in Figure 3a, during a scanning operation the patterning device MA will move from a first scanning position to a second scanning position (in the scanning direction Y) over the course of time T, where T may be approximately 70 ms. As depicted in Figure 3b, over the course of each scanning operation the masking blades 201 will move from a closed configuration, to an open configuration, and back to a closed configuration. As described in relation to Figure 2a, a high pressure region 205 is formed below the patterning device MA if the nozzle 203 provides a flow of protective gas when the masking blades 201 are in the closed configuration. As such, if the nozzle 203 continuously supplies a flow of protective gas during the scanning operation, the mini-environment around the patterning device MA will experience relatively large and frequent fluctuations in pressure (as depicted in Figure 3c).

As discussed in relation to Figure 2b, the formation of a high-pressure region 205 may deform the protective membrane PL, reducing the accuracy of the projection at the substrate W level. Further, relatively large and frequent fluctuations in pressure in the mini-environment around the patterning device MA may also inhibit the performance of optical sensors (e.g., metrology sensors) in proximity to the patterning device MA, degrading measurement accuracy. Relatively large and frequent fluctuations in pressure in the mini-environment around the patterning device may also result in a less stable local flow pattern in proximity to the patterning device MA, increasing perturbations and the risk that contaminants come into contact with the patterning device MA. The above issues in relation to pressure fluctuations will be present in examples in which the patterning device MA comprises a protective membrane PL, and in examples in which the patterning device MA does not comprises a protective membrane PL.

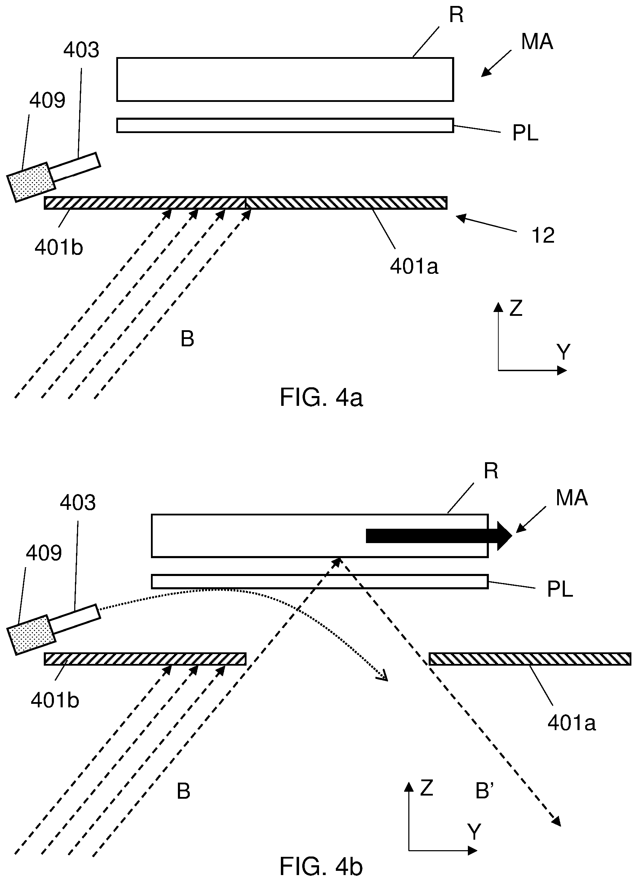

Figures 4a and 4b depict a gas supply apparatus for a lithographic apparatus LA (similar to that shown in Figures 2a and 2b), according to an example of the invention. In the example of Figures 4a and 4b, the gas supply apparatus comprises a nozzle 403 configured to provide a flow of protective gas from a gas source to protect a patterning device MA of the lithographic apparatus LA. The nozzle 403 comprises an opening at the end closest to the patterning device which is configured to direct a flow of protective gas in the direction of the patterning device MA. The size, shape, position and/or orientation of the nozzle 403 may be selected such that the nozzle 403 provides a flow of protective gas to protect the patterning device MA. The flow of protective gas may protect the patterning device MA by exerting a force on contaminants that is directed away from the patterning device MA.

In the example of Figures 4a and 4b, the gas supply apparatus further comprises a valve 409 configured to control a flow rate of the flow of protective gas provided by the nozzle 403. The valve 409 may be configured to control the flow rate of the flow of protective gas provided by the nozzle 403 by narrowing and widening the valve 409. For example, widening the valve 409 may increase the flow rate, whilst narrowing the valve 409 may decrease the flow rate. In some examples, narrowing the valve 409 may comprise closing the valve 409 partially or completely. In some examples, widening the valve 409 may comprise opening the valve 409 partially or completely.

As depicted in Figures 4a and Figure 4b, the valve 409 may be positioned in proximity to a gas supply inlet of the nozzle 403 (i.e., the join between a conduit connecting the nozzle 403 and the gas supply source). In some examples, the valve 409 may positioned at the gas supply inlet of the nozzle. Placing the valve 409 in proximity to the nozzle 403 improves the speed at which the gas supply apparatus can vary the flow rate of the flow of protective gas because a smaller combined volume of nozzle 403 and conduit downstream of the valve 409 is filled or emptied when the valve 409 is switched. Placing the valve 409 at the gas supply inlet of the results in the fastest variation in flow rate because the combined volume of the conduit and nozzle 403 downstream of the valve 409 is minimized (i.e., the conduit volume is substantially zero).

In some examples the valve 409 may be configured to control the flow rate in response to receiving an input from a controller (not shown). In some examples the valve 409 may be connected to a controller. In some examples the valve 409 may be mechanically connected to the controller. In some examples, the valve 409 may be conductively and/or wirelessly connected to the controller. In some examples the valve 409 may be actuated by the controller. In some examples the gas supply apparatus may comprise the controller. In other examples the controller may be separate from, but connected to, the gas supply apparatus and/or the valve 409. The controller may be configured to control the valve 409 based on sensor input related to the masking blades 401 (e.g., indicative of the spacing between the masking blades). The controller may be configured to control the valve 409 based on control input related to the masking blades 401 (e.g., indicative of the relative positions of the masking blades which could be used to infer their spacing).

In the examples of Figure 4a and 4b, the gas supply apparatus is configured to provide the flow of protective gas at a flow rate dependent on the spacing between the plurality of masking blades 401 of the lithographic apparatus LA. The gas supply apparatus may be configured to provide the flow of protective gas from the nozzle 403 at a first flow rate when the plurality of making blades 401 are in a closed configuration.

In the example of Figure 4a, the masking blades 401 are in a closed configuration, and the spacing between the the internal edges of the masking blades 201 has a first spacing value. In some examples, the first spacing value may be less than or equal to 0.005 m^{2.}. As such, in the example of Figure 4a, the gas supply apparatus provides the flow of protective gas from the nozzle 403 at a first flow rate, wherein the first flow rate is substantially zero i.e., the nozzle 403 is not providing a flow of protective gas (as illustrated by the absence of a dotted line flowing from the nozzle in comparison to Figure 2a). In some examples the first flow rate may be non-zero. In some examples the first flow rate may be relatively low. In some examples the first flow rate may greater than zero, and less than a second flow rate (e.g., 150-200 litres/minute, or 0.0025-0.0033 m³/s). In some examples, the first flow rate may be one or more of: less than 0.001 m³/s, less than 0.0001 m³/s, less than 0.00001 m³/s.

By providing the flow of protective gas at a lower and/or low flow rate, the formation of a high-pressure region between the patterning device MA and the masking blades 401 can be avoided. Avoiding the formation of a high-pressure region between the patterning device MA and the masking blades 401 may advantageously reduce deformation of the protective membrane PL, improving the accuracy of the projection at the substrate W level, and/or reducing the risk of rupturing the protective membrane PL. Further, using a lower flow rate does not significantly increase the risk that the patterning device MA will become contaminated because in the closed configuration the masking blades 401 inhibit the transmission of contaminants into the mini-environment around the patterning device MA.

In the example of Figure 4b, the patterning device MA and first masking blade 401a have moved in the scanning direction Y, relative to Figure 4a (as illustrated by the large arrow).

As for Figure 2b, the masking blades 401 depicted in Figure 4b are in an open configuration. In the example of Figure 4b, the internal edges of the masking blades 401 do not abut one another. In some examples, in the open configuration, the area of the spacing between the internal edges of the masking blades 401 may be greater than 0.005 m².

In Figure 4b the flow of protective gas from the nozzle 403 of the gas supply apparatus deflects from the patterning device PL. The masking blades 401 are in an open configuration, and so egress of the flow of the protective gas from mini-environment around the patterning device MA is not inhibited. As such, the formation of a high-pressure region between the masking blades 401 and the patterning device MA is avoided.

In the example of Figure 4b the gas supply apparatus is configured to provide the flow of protective gas at a flow rate dependent on the spacing between the plurality of masking blades 401 of the lithographic apparatus LA. The gas supply apparatus may be configured to provide the flow of protective gas from the nozzle 403 at a second flow rate when the plurality of making blades 401 are in an open configuration. In the example of Figure 4b, the gas supply apparatus provides the flow of protective gas from the nozzle 403 at a second flow rate, wherein the second flow rate is non-zero (as illustrated by the dotted line flowing from the nozzle). In some examples the second flow rate is greater than the first flow rate.

In the examples of Figures 4a and 4b, the gas supply apparatus is configured to provide the flow of protective gas at a flow rate dependent on a spacing between a plurality of masking blades 401 of the lithographic apparatus LA. More specifically, the gas supply apparatus is configured such that when the masking blades 401 are in a closed configuration the gas flow is provided at a first flow rate, and when the masking blades 401 are in an open configuration the gas flow is provided at a second flow rate. In the examples of Figures 4a and 4b the first flow rate is less than the second flow rate i.e., the gas flow rate is lower when the masking blades 401 are in the closed configuration compared to the gas flow rate when the masking blades 401 are in the open configuration. In some examples, control of the valve 409 is synchronised with the open/closed configuration of the masking blades 401 such that the gas flow is dependent on the spacing between the masking blades 401. The skilled person would appreciate that any number of different flow rates could be used (e.g, a third flow rate, a fourth flow rate, ..., a nth flow rate). The skilled person would also appreciate that any other suitable dependency may be used. For example, the flow rate may be proportional to the spacing between the masking blades 401 (e.g., flow rate = k × spacing, where k is a constant). However, the skilled person would appreciate that any other suitable mathematical function (e.g., step function, exponential function) could be used to describe the dependency of the flow rate on the spacing between the masking blades 401.

In some examples, the gas supply apparatus may be configured to provide the flow of protective gas at the first flow rate by narrowing the valve 409. In some examples, the gas supply apparatus may be configured to provide the flow of protective gas at the second flow rate by widening the valve 409. As discussed above, narrowing the valve 409 may comprise closing the valve 409 partially or completely. Similarly, widening the valve 409 may comprise opening the valve 409 partially of completely.

In some examples, the valve 409 may be a piezoelectric valve. In some examples, the valve 409 may be a high-speed modulation valve and/or a high-speed switching valve. In some examples, the valve 409 may have a switching time of less than time T, i.e., the time for the patterning device MA to complete one scan of a scanning operation. As discussed in relation to Figure 3b, over the course of time T the masking blades 201, 401 will transition from a closed configuration to an open configuration, and back to a closed configuration. In order for the gas supply apparatus to provide the gas flow at gas flow rate dependent on the spacing between the masking blades 401, it is beneficial for the gas supply apparatus take less time to vary the gas flow rate than the time it takes for the patterning device MA to complete one scan (i.e., moving from the first scanning position to the second scanning position). As such, the valve 409 may have a switching time of one or more of: less than the time for the patterning device to complete one scan; less than or equal to 70 ms, less than or equal to 10 ms, less than or equal to 5 ms, less than or equal to 2 ms, less than or equal to 1 ms. Using a faster valve 409 switching time enables the gas supply apparatus to respond more quickly to the change in spacing between the masking blades 401, allowing for more precise control/dependency of the gas flow rate on the masking blade 401 spacing.

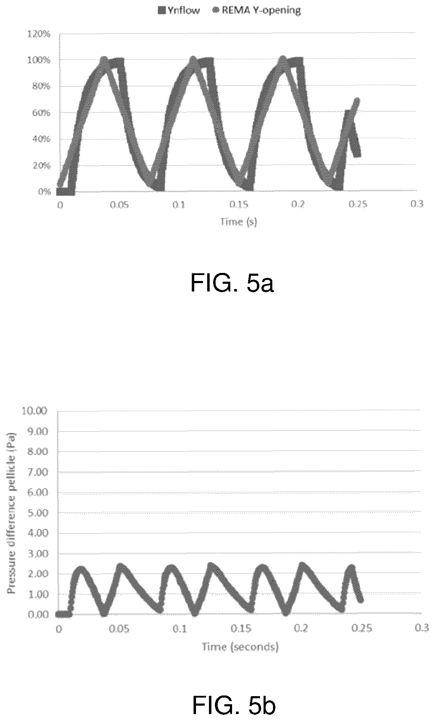

Similarly to Figure 3b, Figure 5a depicts opening between the masking blades 401 during successive scanning operations. During each scanning operation the masking blades 401 will move from a closed configuration, to an open configuration, and back to a closed configuration. Whilst in the example of Figures 2a, 2b, 3a, 3b, and 3c, the flow rate of the flow of protective gas remains substantially continuous as the masking blades 201 open and close, in the example of Figure 5a, the flow rate of the flow of protective gas is dependent on the spacing between the masking blades 401. Specifically, in the example of Figure 5a, the flow rate of the flow of protective gas increases as the spacing between the masking blades 401 increases, and decreases as the spacing between the masking blades 401 decreases. The skilled person would appreciate that other dependencies may also provide the beneficial effects described.

Similarly to Figure 3c, Figure 5b depicts the fluctuations in pressure in the mini-environment around the patterning device MA during successive scanning operations. As will be appreciated though comparison between these Figures 3c and 5b, the pressure difference (dP = Pₘₐₓ-Pₘᵢₙ) for each scanning operation is significantly smaller when the flow rate of the flow of protective gas is dependent on the spacing between the masking blades 401 (i.e., Figure 5b). In the example of Figure 5b, dP is approximately 2.5 Pa. Whilst in the example of Figure 3b, dP is approximately 8 Pa. As will be appreciated, providing the flow of protective gas at a flow rate dependent on the spacing between the masking blades 401 therefore has the technical effect of reducing pressure variations in the mini-environment around the patterning device MA. This technical effect has the advantage of reducing scale of deformation of the protective membrane PL, reducing the risk of damage to the protective membrane PL and improving overlay accuracy (as previously discussed). This technical effect also has the advantage of the improving the performance of optical sensors (e.g., metrology sensors) in proximity to the patterning device MA, by reducing the pressure fluctuations which degrade measurement accuracy. This technical effect also results in a more stable local flow pattern in proximity to the patterning device MA, reducing gas flow perturbations and the associated risk that contaminants come into contact with the patterning device MA.

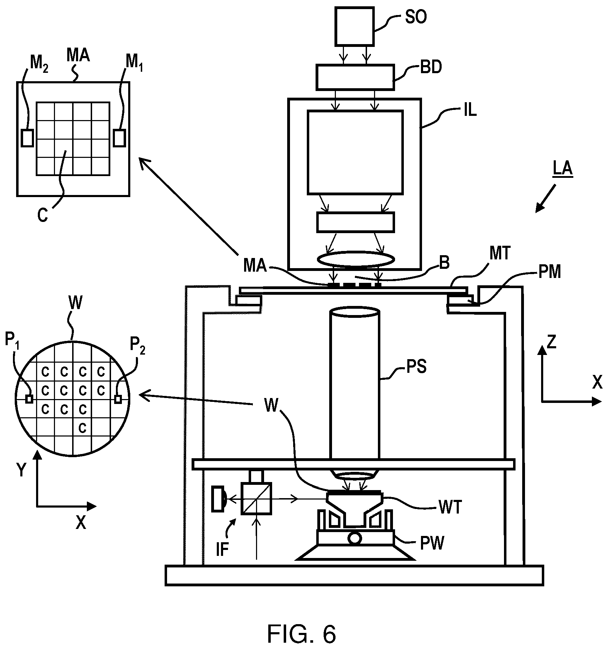

Figure 6 schematically depicts a second lithographic apparatus LA (e.g., a DUV lithographic apparatus). The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 6) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

In some examples the patterning device MA may be a reticle and/or any other suitable patterning device. The patterning device MA may further comprise a protective membrane. The protective membrane may be configured to inhibit contamination of the patterning device MA. The protective membrane may be a pellicle and/or any other suitable protective membrane.

As for the first lithographic apparatus, the second lithographic apparatus LA also comprises one or more protective gas sources, and one or more protective gas supply apparatus in fluid communication with the one or more protective gas sources. The protective gas supply apparatus may be configured to provide a flow of protective gas to various elements of the lithographic apparatus LA (e.g., the patterning device MA), to inhibit the passage of contaminants to the patterning device MA. The protective gas may be hydrogen, or any other suitable gas and/or fluid for this purpose.

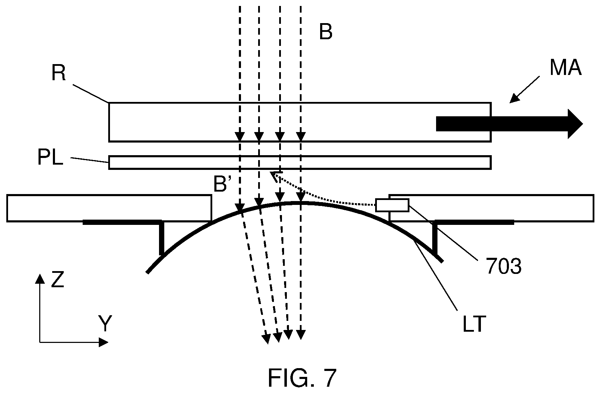

Figure 7 depicts a more detailed view of the lens top mini-environment (LTME) in the region below the patterning device MA of the lithographic apparatus depicted in Figure 6. As depicted in Figure 7, the radiation beam B (dashed lines) passes through the patterning device MA to form a patterned radiation beam B', and the patterned radiation beam B' passes into a lens top element LT of the projection system PS.

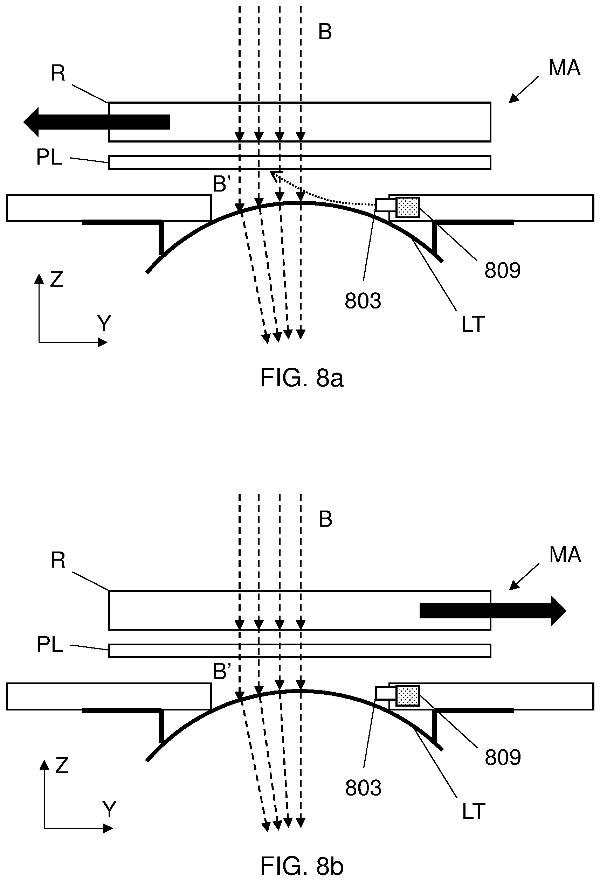

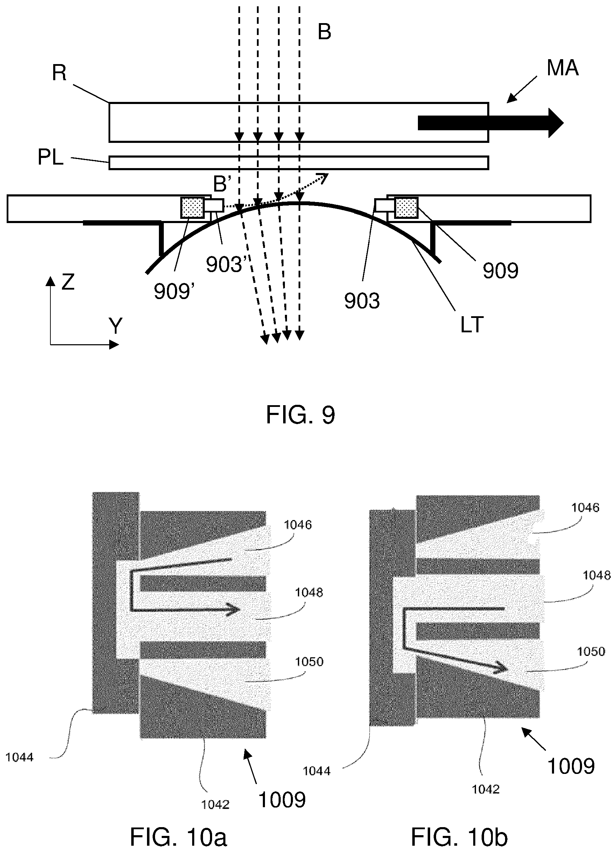

In the example of Figure 7 (and Figures 8a, 8b and 9), the patterning device MA comprises a mask and/or reticle R and a protective membrane PL. In some examples (not shown), the patterning device MA comprises a mask and/or reticle R, but does not comprise a protective membrane PL.

In the example of Figure 7, a gas supply apparatus for the lithographic apparatus LA comprises a nozzle 703. The nozzle 703 is configured to supply a flow of protective gas (dotted line) from a gas source (not shown) to protect the lens top element LT of the lithographic apparatus LA. In the example of Figure 7, the nozzle 703 is positioned between the lens top element LT and the patterning device MA with respect to the Z direction. In some examples the nozzle 703 may be positioned such that a component of the protective gas flow is directed parallel to the scanning axis Y of the patterning device MA. The gas flow provided by the nozzle 703 is configured to force contaminants away from the lens top element LT, thereby reducing contamination of the lens top element LT. Contamination of the lens top element LT may absorb and/or scatter the patterned radiation beam B' and thereby reduce the accuracy of the projection at the substrate W level, reducing the performance of the lithographic apparatus LA.

As depicted in Figure 7, the gas flow provided by the nozzle 703 deflects off the lens top element LT towards the patterning device MA. During a first step of a scanning operation, the patterning device MA will move in the scanning axis Y, in a scanning direction away from the nozzle 703. Whilst in a second step of the scanning operation, the patterning device MA will move in the scanning axis Y, in a scanning direction towards the nozzle 703 (as depicted by the large arrow in Figure 7). When the patterning device MA moves in the direction towards the nozzle 403, the deflected gas flow impinges perpendicularly onto the patterning device MA. Whereas, when the patterning device moves in a direction away from the nozzle, the deflected gas flow does not impinge perpendicularly to the patterning device MA. The deflected gas flow impinging perpendicularly to the patterning device MA produces a large increase in stagnation pressure on the patterning device MA, increasing the risk that contaminants come into contact with the patterning device MA. Contamination of the patterning device MA may also result in a reduction in the accuracy of the projection at the substrate W level, reducing the performance of the lithographic apparatus LA.

In the example of Figure 7, the patterning device MA comprises a protective membrane PL (e.g., a pellicle). When the gas flow impinges obliquely on the protective membrane PL, the protective membrane PL may be deformed to a greater extent, compared to the case where the gas flow does not impinge obliquely on the protective membrane PL (i.e., when the scanning motion is not contrary to the protective gas flow), as a result of the increased pressure on the protective membrane. As the patterned radiation beam B' passes through the protective membrane PL, deformation of the protective membrane PL may cause undesirable absorption and/or refraction of the patterned radiation beam B', resulting in a reduction in the accuracy of the projection at the substrate W level. Whilst the protective membrane PL may be deformed to a lesser extent when the patterning device MA moves in a direction away from the nozzle 703, the resulting variation in deformation caused by the scanning direction of the patterning device MA may be difficult to compensate for.

Figures 8a and 8b depict a gas supply apparatus for a lithographic apparatus LA, comprising a nozzle 803 configured to provide a flow of protective gas from a gas source to protect a lens top element LT of the lithographic apparatus LA. In the example of Figures 8a and 8b, the gas supply apparatus further comprises a valve 809 configured to control a flow rate of the flow of protective gas provided by the nozzle 803. Further, in the example of Figures 8a and 8b, the gas supply apparatus is configured to provide the flow of protective gas at a flow rate dependent on a scan motion of a patterning device MA relative to the nozzle 803.

In Figure 8a, the scan motion of the patterning device MA is directed away from the nozzle 803 in the scanning axis Y (as illustrated by the large arrow). In the example of Figure 8a, the gas supply apparatus is configured to provide the flow of protective gas from the nozzle 803 at a first flow rate when the scan motion of the patterning device MA is directed away from the nozzle 803. In the example of Figure 8a, the gas supply apparatus provides the flow of protective gas from the nozzle 803 at a first flow rate, wherein the first flow rate is non-zero (as illustrated by the presence of the dotted line flowing from the nozzle). In some examples the first flow rate is a standard flow rate (e.g., 150-200 litres/minute, or 0.0025-0.0033 m³/s).

In Figure 8b, the scan motion of the patterning device MA is directed towards the nozzle 803 in the scanning axis Y. In the example of Figure 8b, the gas supply apparatus is configured to provide the flow of protective gas from the nozzle 803 at a second flow rate when the scan motion of the patterning device MA is directed towards the nozzle 803. In the example of Figure 8b, the gas supply apparatus provides the flow of protective gas from the nozzle 803 at a second flow rate, wherein the second flow rate is substantially zero i.e., the nozzle is not providing a flow of protective gas (as illustrated by the absence of a dotted line flowing from the nozzle 803). In some examples the second flow rate may be non-zero. In some examples the second flow rate may be relatively low. In some examples the second flow rate may greater than zero, and less than a first flow rate (e.g., 150-200 litres/minute, or 0.0025-0.0033 m³/s). In some examples, the second flow rate may be one or more of: less than 0.001 m³/s, less than 0.0001 m³/s, less than 0.00001 m³/s.

In the examples of Figures 8a and 8b, the first flow rate is greater than the second flow rate. In the examples of Figures 8a and 8b, the gas supply apparatus increases the gas flow rate (to the first flow rate from the second flow rate) when the scan motion of the patterning device MA is directed away from the nozzle 803, and decreases the gas flow rate when the scan motion of the patterning device MA is directed towards the nozzle 803. In this way, the flow rate of the flow of protective gas is dependent on the scan motion of the patterning device MA. In some examples, control of the valve 809 is synchronised with the scanning motion of the patterning device MA such that the gas flow is dependent on the scanning motion of the patterning device. The skilled person would appreciate that any number of different flow rates could be used (e.g, a third flow rate, a fourth flow rate, ..., a nth flow rate). The skilled person would also appreciate that any other suitable dependency may be used. For example, the flow rate may be proportional to the velocity and/or position of the patterning device MA relative to the nozzle 803 (e.g., flow rate = k × velocity, where k is a constant). However, the skilled person would appreciate that any other suitable mathematical function (e.g., step function, exponential function) could be used to describe the dependency of the flow rate on the scan motion of a patterning device MA relative to the nozzle 803.

By reducing the flow rate of the flow of protective gas when the scan motion of the patterning device MA is directed towards the nozzle 803, the gas flow from the nozzle 803 exerts a smaller force on the protective membrane PL, reducing deformation of the protective membrane PL. Reduced deformation of the protective membrane PL reduces undesirable refraction of the patterned radiation beam B', improving projection/overlay accuracy at the substrate W. Further, reducing deformation of the protective membrane PL, particularly when the scan motion of the patterning device MA is directed towards the nozzle 803, improves the consistency of the projection across the scanning operation in which the patterning device moves towards and away from the nozzle 803 in the scanning axis Y.

As previously described, the gas supply apparatus further comprises a valve 809 configured to control a flow rate of the flow of protective gas provided by the nozzle 803. The valve 809 may be configured to control the flow rate of the flow of protective gas provided by the nozzle 803 by narrowing and widening the valve 809. For example, widening the valve 809 may increase the flow rate, whilst narrowing the valve 809 may decrease the flow rate. In some examples, narrowing the valve 809 may comprise closing the valve 809 partially or completely. In some examples, widening the valve 809 may comprise opening the valve 809 partially or completely. The gas supply apparatus may be configured to provide the flow of protective gas from the nozzle 803 at the first flow rate by widening the valve 809, and the gas supply apparatus may be configured to provide the flow of protective gas from the nozzle 803 at the second flow rate by narrowing the valve 809.

In some examples, the valve 809 may be a piezoelectric valve. In some examples, the valve 809 may be a high-speed modulation valve and/or a high-speed switching valve. In some examples, the valve 809 may have a switching time of less than a time for the patterning device MA to complete a single scan (i.e., the patterning device moving from a first Y position to a second Y position, and then returning to the first Y position). The valve 809 may have a switching time of one or more of: less than the time for the patterning device MA to complete one scan; less than or equal to 70 ms, less than or equal to 10 ms, less than or equal to 5 ms, less than or equal to 2 ms, less than or equal to 1 ms.

Using a faster valve 809 switching time enables the gas supply apparatus to respond more quickly to the change in direction of the patterning device MA, allowing for more precise dependency of the gas flow rate on the scan motion of a patterning device relative to the nozzle.

As depicted in Figures 8a and 8b, the valve 809 may be positioned in proximity to a gas supply inlet of the nozzle 803 (i.e., the join between a conduit connecting the nozzle and the gas supply source). In some examples, the valve 809 may positioned at the gas supply inlet of the nozzle 803. Placing the valve 809 in proximity to the gas supply inlet of the nozzle 803 improves the speed at which the gas supply apparatus can vary the flow rate of the flow of protective gas because a smaller combined volume of nozzle 803 and conduit downstream of the valve 809 is filled or emptied when the valve 809 is switched. Placing the valve 809 at the gas supply inlet of the nozzle 803 results in the fastest variation in flow rate because the combined volume of the conduit and nozzle 803 downstream of the valve 809 is minimized (i.e., the conduit volume is substantially zero).

In some examples the valve 809 may be configured to control the flow rate in response to receiving an input from a controller. In some examples the valve 809 may be connected to a controller. In some examples the valve 809 may be mechanically connected to the controller. In some examples, the valve 809 may be conductively and/or wirelessly connected to the controller. In some examples the valve 809 may be actuated by the controller. In some examples the gas supply apparatus may comprise the controller. In other examples the controller may be separate from, but connected to, the gas supply apparatus and/or the valve 809. The controller may be configured to control the valve 809 based on sensor input related to the scan motion of the patterning device MA (e.g., indicative of the direction of motion of the scan device MA). The controller may be configured to control the valve 809 based on a control input related to the scan motion of the patterning device MA.

In the example of Figure 9 the gas supply apparatus depicted in Figures 8a and 8b, further comprises an auxiliary nozzle 903' configured to provide an auxiliary flow of protective gas from an auxiliary gas source to the patterning device MA of the lithographic apparatus LA. In the example of Figure 9, the gas supply apparatus comprises an auxiliary valve 909' configured to control the flow rate of the auxiliary flow of protective gas from the auxiliary nozzle 903'.

As depicted in the example of Figure 9, the auxiliary nozzle 903' may be positioned such that the auxiliary flow of protective gas provided by the auxiliary nozzle 903' flows in, one or more of: a different direction to the flow of protective gas provided by the nozzle 903; an opposite direction to the flow of protective gas provided by the nozzle 903. The skilled person would appreciate that the auxiliary nozzle 903' could be positioned such that the auxiliary flow of protective gas has an alternative spatial relationship to the flow of protective gas provided by the nozzle 903.

In some examples, the gas supply apparatus may be configured to provide the auxiliary flow of protective gas from the auxiliary nozzle 903' at a third flow rate when the motion of the patterning device MA is directed away from the auxiliary nozzle. In some examples, the gas supply apparatus may be configured to provide the auxiliary flow of protective gas from the auxiliary nozzle 903' at a fourth flow rate when the motion of the patterning device is directed towards the auxiliary nozzle 903'. The third flow rate may be greater than the fourth flow rate. In some examples, the third flow rate may be similar to the first flow rate, and the fourth flow rate may be similar to the second flow rate. In some examples the third flow rate may be equal to the first flow rate, and the fourth flow rate may be equal to the second flow rate.

In the example of Figure 9, the use of an auxiliary nozzle 903' ensures that the flow of protective gas can be provided in the scan direction of the patterning device MA across the whole of a scanning operation, enabling the lithographic apparatus LA to maintain the same protective gas flow condition with respect to the frame of reference of the patterning device MA. Maintaining the same protective gas flow condition further reduces variations in deformation of the protective membrane PL during scan operations compared to the single nozzle example (presented in Figures 8a and 8b), resulting in further improvements to the projection accuracy at the substrate W level. Additionally, the use of the auxiliary nozzle 903' ensures a constant flow of refreshment protective gas is provided, diluting the concentration of contaminants in the lens top mini environment (LTME). As previously discussed, contaminants may interfere with the patterned radiation beam B' reducing projection accuracy and damage the optical surface (LT). Diluting the concentration of contaminants in the lens top mini-environment, therefore improves the projection accuracy of the lithographic apparatus LA.

In some examples, the auxiliary gas source may be the same as the gas source. This configuration advantageously enables a single gas source to be used, reducing the complexity and cost of the gas supply apparatus.

In some examples where the auxiliary gas source may be the same as the gas source, the auxiliary valve 909' may be the valve 909 (i.e., a single valve switches the supply of protective gas from the shared gas source between the nozzle 903' and the auxiliary nozzle 903'). Such an embodiment may reduce the number of components required to implement the gas supply apparatus, making the gas supply apparatus less expensive and mechanically simpler.

In some examples, the auxiliary gas source may be different from the gas source and/or the auxiliary valve 909' may be different from the valve 909.

Figure 10 depicts a valve 1009 configured to control a flow rate of protective gas provided by a nozzle 403, 803. The valve 1009 depicted in Figure 10 is suitable for use in the gas supply apparatus described in relation to Figures 4a, 4b, 8a, 8b, and 9.

The valve 1009 operates in a sliding fashion to toggle between an on state (protective gas provided to the nozzle 403, 803, 903, 903' and the mini-environment around the patterning device MA) and an off state (protective gas vented away from the nozzle 403, 803, 903, 903' and the mini-environment around the patterning device MA).The valve 1009 comprises a housing 1042 and a sliding member 1044. The sliding member 1044 is arranged to slide between a first position (Figure 10a) and a second position (Figure 10b). In the first position, the sliding member 1044 is positioned such that a protective gas ingress 1046 is in fluid communication with a cavity 1048. The protective gas ingress 1046 may be in fluid communication with a conduit connected to a gas source. The cavity 1048 is in fluid communication with a nozzle 403, 803, 903, 903' configured to provide a flow of protective gas to a patterning device MA. In the first position, a fluid path between a vent 1050 and the cavity 1048 is blocked by the housing 1042. In the second position, the fluid path between the protective gas ingress 1046 and the cavity 1048 is blocked by the housing 1042 , preventing protective gas from passing into the nozzle 403, 803 and therefore the mini-environment around the patterning device MA. In the second position, the vent 1050 is in fluid communication with the cavity 1048 allowing protective gas to vent from the nozzle 403, 803, 903, 903' and/or the mini-environment around the patterning device MA.

Widening and/or opening the valve 1009 may comprise moving the sliding member 1044 from the second position to the first position. Narrowing and/or closing the valve 1009 may comprise moving the sliding member 1044 from the first position to the second position. As described above, in some examples, a controller may be configured to control the valve 1009. The controller may be configured to control the valve 1009 by moving the sliding member 1044 between the first and second positions. The controller may be configured to control the valve by causing the sliding member 1044 to move between the first and second positions (e.g., through communication with an actuator).

In some examples, a gap may be maintained between the sliding member 1044 and the housing 1042 so as to prevent contaminants from entering the flow of cooling gas. Such a gap is visible in Figures 10a and 10b. As described above, in some examples, the gap may be selected such that, in the closed position, 97% of the flow of protective gas is prevented from entering the cavity 1048.

In some examples the vent 1050 may be absent, and so in the second position the valve 1009 does not perform a venting function for the protective gas.

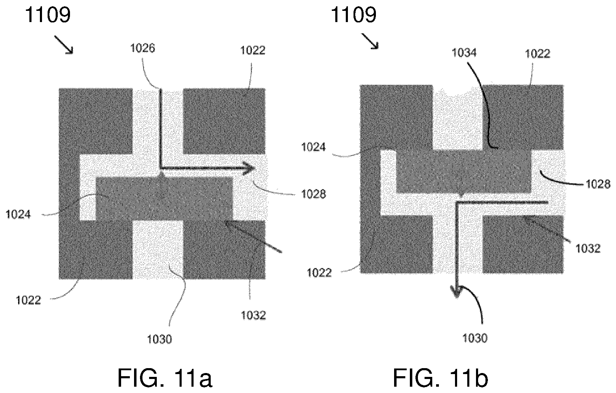

Figure 11 depicts a valve 1109 configured to control a flow rate of protective gas provided by a nozzle 403, 803. The valve 1109 depicted in Figure 11 is suitable for use in the gas supply apparatus described in relation to Figures 4a, 4b, 8a, 8b, and 9. The valve 1109 operates in a sliding fashion to toggle between an on state (protective gas provided to the nozzle 403, 803, 903, 903' and the mini-environment around the patterning device MA) and an off state (protective gas vented away from the nozzle 403, 803, 903, 903' and the mini-environment around the patterning device MA). The valve 1109 comprises a housing 1022 and a sliding member 1024. The sliding member 1024 is arranged to slide between a first position (Figure 11a) and a second position (Figure 11b). In the first position, a protective gas ingress 1026 is in fluid communication with the cavity 1028 such that protective gas flows from the ingress 1026 , through the cavity 1028 towards the mini-environment around the patterning device MA. A fluid path from the cavity 1028 and a vent 1030 is blocked by the abutment or closer proximity of the sliding member 1024 against the housing 1022 . The protective gas ingress 1026 may be in fluid communication with a conduit connected to a gas source. The cavity 1028 is in fluid communication with a nozzle 403, 803, 903, 903' configured to provide a flow of protective gas to a patterning device MA. In the second position, the fluid path between the ingress 1026 and the cavity 1028 is closed or restricted through interaction between the sliding member 1024 and the housing 1022. As such, protective gas is prevented from flowing from the ingress 1026 to the cavity 1028 . In the second position, the vent 1030 is in fluid communication with the cavity 1028 to allow protective gas already present in the nozzle 403, 803, 903, 903' and/or the mini-environment around the patterning device MA to egress through the valve 1109.Widening and/or opening the valve 1109 may comprise moving the sliding member 1024 from the second position to the first position. Narrowing and/or closing the valve 1109 may comprise moving the sliding member 1024 from the first position to the second position. As described above, in some examples, a controller may be configured to control the valve 1109. The controller may be configured to control the valve 1109 by moving the sliding member 1024 between the first and second positions. The controller may be configured to control the valve by causing the sliding member 1024 to move between the first and second positions (e.g., through communication with an actuator).

So as to prevent contamination, it may be desirable to prevent particles from entering the stream of protective gas and being carried to the substrate W. As such, the valve 1109 may be constructed such that a gap is maintained between the sliding member 1024 and the housing 1022 at all times. That is, in some embodiments, the valve 1109 is constructed such that no part of the valve 1109 which comes into contact with the flow of cooling gas comes into physical contact with the housing 1022 . For example, in Figure 11a an arrow 1032 points to a location at which the sliding member 1024 is closest to the housing 1022 in the first ("open") position. In some embodiments, a small gap is maintained between the sliding member 1024 and the housing 1022 at the location pointed to by arrow 1032 . Similarly, with reference to FIG. 11b , in the second ("closed") position, the sliding member 1024 may be separated from the housing 1022 at the position 1034. While this may mean that a small quantity of protective gas is able to enter the cavity 1028 (and therefore the nozzle 403, 803, 903, 903' and/or the mini-environment around the patterning device MA) when the valve 1109 is in the closed position, the protective gas will be sufficiently reduced. For example, the size of a gap maintained between the sliding member 1024 and the housing 1022 may be selected so as to prevent 97% of the open flow of protective gas when the valve 1109 is in the closed position.

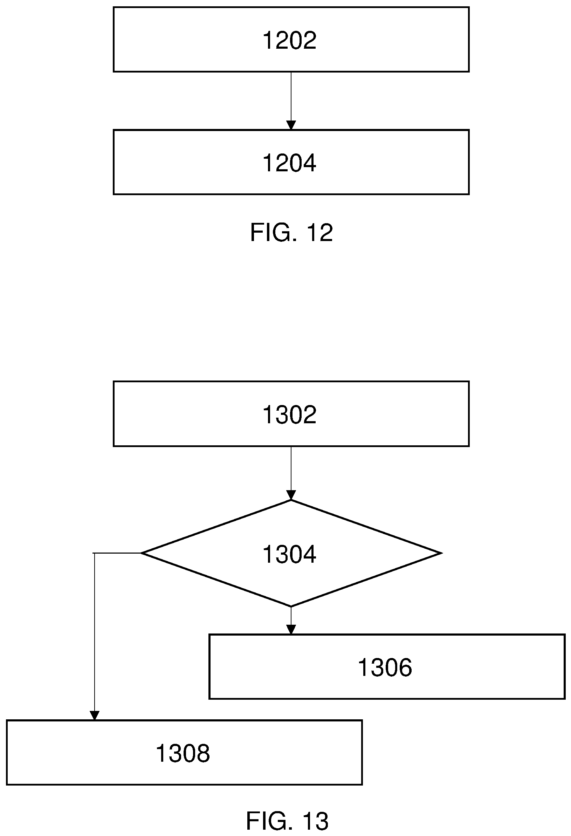

Figure 12 depicts a method of providing a flow of protective gas to protect a patterning device MA of a lithographic apparatus LA using a gas supply apparatus.

In examples where the gas supply apparatus is as described in relation to Figures 1 to 5b, block 1202 of the method comprises determining a spacing between a plurality of masking blades 401 of the lithographic apparatus LA. In such examples, block 1204 of the method comprises adjusting, dependent on the spacing between the plurality of masking blades 401, the flow rate of the flow of protective gas from a nozzle 403 of the gas supply apparatus. As discussed in relation to Figures 1 to 5b, 10a to 10b, and 11a to 11b, the flow rate of the flow of protective gas is adjusted using a valve 409, 1009, 1109 of the gas supply apparatus.

In examples where the gas supply apparatus is as described in relation to Figures 6 to 9, block 1202 of the method comprises determining a scan motion of the patterning device MA relative to a nozzle of the gas supply apparatus. In such examples, block 1204 of the method comprises adjusting, dependent on the scan motion of the patterning device relative to the nozzle 803, 903, 903', the flow rate of the flow of protective gas. As discussed in relation to Figures 6 to 11, the flow rate of the flow of protective gas is adjusted using a valve 809, 909, 909', 1009, 1109 of the gas supply apparatus.

Figure 13 depicts a method of providing a flow of protective gas to protect a patterning device MA of a lithographic apparatus LA using a gas supply apparatus, similar to Figure 12.

In examples where the gas supply apparatus is as described in relation to Figures 1 to 5b, block 1302 of the method comprises determining a spacing between a plurality of masking blades 401 of the lithographic apparatus LA. In such examples, block 1304 of the method comprises adjusting, dependent on the spacing between the plurality of masking blades 401, the flow rate of the flow of protective gas from a nozzle 403 of the gas supply apparatus. In block 1306, when the plurality of making blades 401 are in a closed configuration, adjusting the flow rate comprises providing the flow of protective gas from the nozzle 403 at a first flow rate. In block 1308, when the plurality of masking blades 401 are in an open configuration, adjusting the flow rate comprises providing the flow of protective gas from the nozzle 403 at a second flow rate. In this example, the first flow rate is less than the second flow rate. As discussed in relation to Figures 1 to 5b, 10a-10b, and 11a-11b, the flow rate of the flow of protective gas is adjusted using a valve 409, 1009, 1109 of the gas supply apparatus.

In examples where the gas supply apparatus is as described in relation to Figures 6 to 9, block 1302 of the method comprises determining a scan motion of the patterning device MA relative to a nozzle 803, 903, 903' of the gas supply apparatus. In such examples, block 1304 of the method comprises adjusting, dependent on the scan motion of the patterning device MA relative to the nozzle 803, 903, 903', the flow rate of the flow of protective gas. In block 1306, when the scan motion of the patterning device MA is directed away from the nozzle 803, 903, 903', adjusting the flow rate comprises providing the flow of protective gas from the nozzle 803, 903, 903' at a first flow rate. In block 1308, when the scan motion of the patterning device MA is directed towards the nozzle 803, 903, 903', adjusting the flow rate comprises providing the flow of protective gas from the nozzle 803, 903, 903' at a second flow rate. In this example, the first flow rate is greater than the second flow rate. As discussed in relation to Figures 6 to 11b, the flow rate of the flow of protective gas is adjusted using a valve 809, 909, 909', 1009, 1109 of the gas supply apparatus.

The methods of Figures 12 and 13 may be computer implemented methods. The methods of Figures 12 and 13 may be computer implemented methods performed by a controller in connection with the gas supply apparatus.

Selected components of Figures 1 and 6 depict a lithographic apparatus comprising: an illumination system configured to condition a radiation beam; a support structure constructed to support a patterning device, the patterning device being capable of imparting the radiation beam with a pattern in its cross-section to form a patterned radiation beam; a gas source; and a gas supply apparatus, in fluid communication with the gas source, as described throughout the description.

Figures 1-5b, and Figures 6-9 both relate a gas supply apparatus for a lithographic apparatus LA, comprising: a nozzle configured to provide a flow of protective gas from a gas source to protect a patterning device of the lithographic apparatus; and a valve configured to control a flow rate of the flow of protective gas provided by the nozzle. In both examples, the valve is as described in relation to Figures 10a and 10b.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims and clauses set out below.
1. A gas supply apparatus for a lithographic apparatus, comprising:
   a nozzle configured to provide a flow of protective gas from a gas source to protect a patterning device of the lithographic apparatus; and
   a valve configured to control a flow rate of the flow of protective gas provided by the nozzle;
   wherein the gas supply apparatus is configured to provide the flow of protective gas at a flow rate dependent on a spacing between a plurality of masking blades of the lithographic apparatus.
2. A gas supply apparatus as claimed in clause 1, wherein:
   the gas supply apparatus is configured to provide the flow of protective gas from the nozzle at a first flow rate when the plurality of making blades are in a closed configuration; and
   the gas supply apparatus is configured to provide the flow of protective gas from the nozzle at a second flow rate when the plurality of masking blades are in an open configuration;
   the first flow rate is less than the second flow rate.
3. A gas supply apparatus as claimed in clause 2, wherein:
   the gas supply apparatus is configured to provide the flow of protective gas at the first flow rate by narrowing the valve; and
   the gas supply apparatus is configured to provide the flow of protective gas at the second flow rate by widening the valve.
4. A gas supply apparatus as claimed in any preceding clause, wherein the valve has a switching time of less than or equal to 10 ms.
5. A gas supply apparatus as claimed in any preceding clause, wherein the valve is positioned in proximity to a gas supply inlet of the nozzle.
6. A gas supply apparatus as claimed in any preceding clause, wherein the valve is a piezoelectric valve.
7. A gas supply apparatus as claimed in any preceding clause, wherein the valve is configured to control the flow rate in response to receiving an input from a controller.
8. A method of providing a flow of protective gas to protect a patterning device of a lithographic apparatus using a gas supply apparatus, the method comprising:
   determining a spacing between a plurality of masking blades of the lithographic apparatus; and
   adjusting, dependent on the spacing between the plurality of masking blades, the flow rate of the flow of protective gas from a nozzle of the gas supply apparatus;
   wherein, the flow rate of the flow of protective gas is adjusted using a valve of the gas supply apparatus.
9. A method of providing protective gas as claimed in clause 8, wherein adjusting the flow rate of the flow of protective gas comprises:
   providing the flow of protective gas from the nozzle at a first flow rate when the plurality of making blades are in a closed configuration; and
   providing the flow of protective gas from the nozzle at a second flow rate when the plurality of masking blades are in an open configuration;
   wherein, the first flow rate is less than the second flow rate.
10. A gas supply apparatus for a lithographic apparatus, comprising:
   a nozzle configured to provide a flow of protective gas from a gas source to protect a lens top element of the lithographic apparatus; and
   a valve configured to control a flow rate of the flow of protective gas provided by the nozzle;
   wherein the gas supply apparatus is configured to provide the flow of protective gas at a flow rate dependent on a scan motion of a patterning device relative to the nozzle.
11. A gas supply apparatus as claimed in clause 10, wherein:
   the gas supply apparatus is configured to provide the flow of protective gas from the nozzle at a first flow rate when the scan motion of the patterning device is directed away from the nozzle;
   the gas supply apparatus is configured to provide the flow of protective gas from the nozzle at a second flow rate when the scan motion of the patterning device is directed towards the nozzle; and
   the first flow rate is greater than the second flow rate.
12. A gas supply apparatus as claimed in clause 11, wherein:
   the gas supply apparatus is configured to provide the flow of protective gas from the nozzle at the first flow rate by widening the valve; and
   the gas supply apparatus is configured to provide the flow of protective gas from the nozzle at the second flow rate by narrowing the valve.
13. A gas supply apparatus as claimed in any of clauses 10 to 12, wherein the valve has a switching time of less than or equal to 10 ms.
14. A gas supply apparatus as claimed in any of clauses 10 to 13, wherein the valve is positioned in proximity to a gas supply inlet of the nozzle.
15. A gas supply apparatus as claimed in any of clauses 10 to 14, wherein the valve is a piezoelectric valve.
16. A gas supply apparatus as claimed in any of clauses 10 to 15, wherein the valve is configured to control the flow rate in response to receiving an input from a controller.
17. A gas supply apparatus as claimed in any of clauses 10-16, further comprising:
   an auxiliary nozzle configured to provide an auxiliary flow of protective gas from an auxiliary gas source to the patterning device of the lithographic apparatus; and
   an auxiliary valve configured to control the flow rate of the auxiliary flow of protective gas from the auxiliary nozzle.
18. A gas supply apparatus as claimed in clause 17, wherein the auxiliary nozzle is positioned such that the auxiliary flow of protective gas provided by the auxiliary nozzle flows in, one or more of: a different direction to the flow of protective gas provided by the nozzle; an opposite direction to the flow of protective gas provided by the nozzle.
19. A gas supply apparatus as claimed in clauses 17 or 18, wherein:
   the gas supply apparatus is configured to provide the auxiliary flow of protective gas from the auxiliary nozzle at a third flow rate when the motion of the patterning device is directed away from the auxiliary nozzle;
   the gas supply apparatus is configured to provide the auxiliary flow of protective gas from the auxiliary nozzle at a fourth flow rate when the motion of the patterning device is directed towards the auxiliary nozzle; and
   the third flow rate is greater than the fourth flow rate.
20. A method of providing a flow of protective gas to protect a patterning device of a lithographic apparatus using a gas supply apparatus, the method comprising:
   determining a scan motion of the patterning device relative to a nozzle of the gas supply apparatus; and
   adjusting, dependent on the scan motion of the patterning device relative to the nozzle, the flow rate of the flow of protective gas;
   wherein, the flow rate of the flow of protective gas is adjusted using a valve of the gas supply apparatus.
21. A method of providing protective gas as claimed in clause 20, wherein adjusting the flow rate of the flow of protective gas comprises:
   providing the flow of protective gas from the nozzle at a first flow rate when the scan motion of the patterning device is directed away from the nozzle;
   providing the flow of protective gas from the nozzle at a second flow rate when the scan motion of the patterning device is directed towards the nozzle;
   wherein, the first flow rate is greater than the second flow rate.
22. A lithographic apparatus comprising:
   an illumination system configured to condition a radiation beam;
   a support structure constructed to support a patterning device, the patterning device being capable of imparting the radiation beam with a pattern in its cross-section to form a patterned radiation beam;
   a gas source; and
   a gas supply apparatus, in fluid communication with the gas source, as claimed in any of clauses 1 to 7, or clauses 10 to 19.

## Claims

1. A gas supply apparatus for a lithographic apparatus, comprising:
a nozzle configured to provide a flow of protective gas from a gas source to protect a patterning device of the lithographic apparatus; and
a valve configured to control a flow rate of the flow of protective gas provided by the nozzle;
wherein the gas supply apparatus is configured to provide the flow of protective gas at a flow rate dependent on a spacing between a plurality of masking blades of the lithographic apparatus.

2. A gas supply apparatus as claimed in claim 1, wherein:
the gas supply apparatus is configured to provide the flow of protective gas from the nozzle at a first flow rate when the plurality of making blades are in a closed configuration; and
the gas supply apparatus is configured to provide the flow of protective gas from the nozzle at a second flow rate when the plurality of masking blades are in an open configuration;
the first flow rate is less than the second flow rate.

3. A gas supply apparatus as claimed in claim 2, wherein:
the gas supply apparatus is configured to provide the flow of protective gas at the first flow rate by narrowing the valve; and
the gas supply apparatus is configured to provide the flow of protective gas at the second flow rate by widening the valve.

4. A gas supply apparatus as claimed in any preceding claim, wherein the valve has a switching time of less than or equal to 10 ms.

5. A gas supply apparatus as claimed in any preceding claim, wherein the valve is positioned in proximity to a gas supply inlet of the nozzle.

6. A gas supply apparatus as claimed in any preceding claim, wherein the valve is a piezoelectric valve.

7. A method of providing a flow of protective gas to protect a patterning device of a lithographic apparatus using a gas supply apparatus, the method comprising:
determining a spacing between a plurality of masking blades of the lithographic apparatus; and
adjusting, dependent on the spacing between the plurality of masking blades, the flow rate of the flow of protective gas from a nozzle of the gas supply apparatus;
wherein, the flow rate of the flow of protective gas is adjusted using a valve of the gas supply apparatus.

8. A method of providing protective gas as claimed in claim 7, wherein adjusting the flow rate of the flow of protective gas comprises:
providing the flow of protective gas from the nozzle at a first flow rate when the plurality of making blades are in a closed configuration; and
providing the flow of protective gas from the nozzle at a second flow rate when the plurality of masking blades are in an open configuration;
wherein, the first flow rate is less than the second flow rate.

9. A gas supply apparatus for a lithographic apparatus, comprising:
a nozzle configured to provide a flow of protective gas from a gas source to protect a lens top element of the lithographic apparatus; and
a valve configured to control a flow rate of the flow of protective gas provided by the nozzle;
wherein the gas supply apparatus is configured to provide the flow of protective gas at a flow rate dependent on a scan motion of a patterning device relative to the nozzle.

10. A gas supply apparatus as claimed in claim 9, wherein:
the gas supply apparatus is configured to provide the flow of protective gas from the nozzle at a first flow rate when the scan motion of the patterning device is directed away from the nozzle;
the gas supply apparatus is configured to provide the flow of protective gas from the nozzle at a second flow rate when the scan motion of the patterning device is directed towards the nozzle; and
the first flow rate is greater than the second flow rate.

11. A gas supply apparatus as claimed in claim 10, wherein:
the gas supply apparatus is configured to provide the flow of protective gas from the nozzle at the first flow rate by widening the valve; and
the gas supply apparatus is configured to provide the flow of protective gas from the nozzle at the second flow rate by narrowing the valve.

12. A gas supply apparatus as claimed in any of claims 9-11, further comprising:
an auxiliary nozzle configured to provide an auxiliary flow of protective gas from an auxiliary gas source to the patterning device of the lithographic apparatus; and
an auxiliary valve configured to control the flow rate of the auxiliary flow of protective gas from the auxiliary nozzle.

13. A gas supply apparatus as claimed in claim 12, wherein the auxiliary nozzle is positioned such that the auxiliary flow of protective gas provided by the auxiliary nozzle flows in, one or more of: a different direction to the flow of protective gas provided by the nozzle; an opposite direction to the flow of protective gas provided by the nozzle.

14. A gas supply apparatus as claimed in claims 12 or 13, wherein:
the gas supply apparatus is configured to provide the auxiliary flow of protective gas from the auxiliary nozzle at a third flow rate when the motion of the patterning device is directed away from the auxiliary nozzle;
the gas supply apparatus is configured to provide the auxiliary flow of protective gas from the auxiliary nozzle at a fourth flow rate when the motion of the patterning device is directed towards the auxiliary nozzle; and
the third flow rate is greater than the fourth flow rate.

15. A method of providing a flow of protective gas to protect a patterning device of a lithographic apparatus using a gas supply apparatus, the method comprising:
determining a scan motion of the patterning device relative to a nozzle of the gas supply apparatus; and
adjusting, dependent on the scan motion of the patterning device relative to the nozzle, the flow rate of the flow of protective gas;
wherein, the flow rate of the flow of protective gas is adjusted using a valve of the gas supply apparatus.
